(19) Europäisches Patentamt / European Patent Office / Office européen des brevets

(11) **EP 4 693 798 A1**

(12) **EUROPEAN PATENT APPLICATION**
published in accordance with Art. 153(4) EPC

(43) Date of publication:
**11.02.2026  Bulletin 2026/07**

(21) Application number: **23930229.2**

(22) Date of filing: **24.03.2023**

(51) International Patent Classification (IPC):
*H02J 7/00* (2026.01)   *B60L 50/60* (2019.01)
*H01M 10/44* (2006.01)   *H01M 10/48* (2006.01)

(52) Cooperative Patent Classification (CPC):
**B60L 50/60; H01M 10/44; H01M 10/48; H02J 7/00**

(86) International application number:
**PCT/JP2023/011904**

(87) International publication number:
**WO 2024/201588 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Nissan Motor Co., Ltd.**
**Kanagawa 221-0023 (JP)**

(72) Inventors:
• **KOBAYASHI, Rei**
  **Atsugi-shi, Kanagawa 243-0123 (JP)**
• **YAMAGISHI, Takuma**
  **Atsugi-shi, Kanagawa 243-0021 (JP)**

(74) Representative: **Global IP Europe Patentanwaltskanzlei**
**Pfarrstraße 14**
**80538 München (DE)**

(54) **CONTROL DEVICE AND METHOD FOR DETERMINING ALLOWABLE OUTPUT POWER OF BATTERY**

(57)    The present invention includes: a current measurement unit configured to measure a current value of current output from a battery; a voltage measurement unit configured to measure a voltage value of the battery; a first voltage drop amount calculation unit configured to calculate a first voltage drop amount of the battery, based on open-circuit voltage based on the current value and the voltage value; an actual discharge voltage calculation unit configured to calculate actual discharge voltage of the battery cell, based on the first voltage drop amount; a second voltage drop amount calculation unit configured to calculate a second voltage drop amount of the battery when it is assumed that predetermined current is flowed for a predetermined time, based on the actual discharge voltage; a virtual discharge voltage calculation unit configured to calculate virtual discharge voltage of the battery, based on the second voltage drop amount; a resistance value calculation unit configured to calculate a virtual resistance value of the battery, based on the virtual discharge voltage; and a first allowable output power calculation unit configured to calculate first allowable output power, based on the virtual resistance value.

FIG. 2

EP 4 693 798 A1

**Description**

Technical Field

The present invention relates to a control device and a method for determining allowable output power of a battery, and in particular to a control device configured to control allowable output power of a battery and a method for determining the allowable output power of the battery.

Background Art

On vehicles, such as an electric vehicle (EV) and a hybrid vehicle (HV), large capacity and high output batteries are installed. A control system of such a vehicle determines allowable output power according to present voltage of the battery and controls output power (discharging power) from the battery or input power (charging power) to the battery in such a way that the output power or the input power does not exceed a predetermined allowable power. Since a battery deteriorates in an internal state thereof according to a status of use of the vehicle or the like, a technology to prevent such deterioration has been proposed.

For example, Patent Document 1 described below discloses a technology for performing charge and discharge control of a secondary battery to prevent local deterioration inside the battery, based on a battery model that allows prediction of an internal state of the battery.

Citation List

Patent Literature

Patent Document 1: JP 2007-141558 A

Summary of Invention

Technical Problem

The technology described in Patent Document 1 predicts the present state inside the battery, but does not predict the amount of voltage drop when a large current flows from or to the battery, and thus has not been able to appropriately predict the drop in battery voltage. Among other things, in a case where internal battery deterioration progresses or where the battery is used in a harsh environment, the drop in the battery voltage becomes steep, and the control of output voltage cannot respond quickly enough to keep up. In addition, since the technology uses an actual current value from a sensor for prediction of the state, it is difficult to predict the amount of voltage reduction when a large current flows, and it is not possible to perform control assuming the worst-case situation.

Accordingly, an object of the present invention is to provide a technology capable of appropriately predicting the amount of voltage drop according to an internal state of a battery and calculating allowable output power with high precision, based on the predicted amount of voltage drop.

Solution to Problem

The present invention according to one aspect is a control device configured to determine and control allowable output power of a battery in a battery control system. The control device includes: a current measurement unit configured to measure a current value of current output from a battery cell constituting the battery; a voltage measurement unit configured to measure a voltage value of the battery cell; a first voltage drop amount calculation unit configured to calculate a first voltage drop amount of the battery cell, based on open-circuit voltage based on the measured current value and voltage value; an actual discharge voltage calculation unit configured to calculate actual discharge voltage of the battery cell, based on the calculated first voltage drop amount; a second voltage drop amount calculation unit configured to calculate a second voltage drop amount of the battery cell when it is assumed that predetermined current is flowed for a predetermined time, based on the calculated actual discharge voltage; a virtual discharge voltage calculation unit configured to calculate virtual discharge voltage of the battery cell, based on the calculated second voltage drop amount; a resistance value calculation unit configured to calculate a virtual resistance value of the battery cell, based on the calculated virtual discharge voltage; and a first allowable output power calculation unit configured to calculate first allowable output power, based on the calculated virtual resistance value.

In addition, the present invention according to another aspect is a method for determining allowable output power of a battery. The method includes: measuring a current value of current output from a battery cell constituting the battery and also measuring a voltage value of the battery cell; calculating a first voltage drop amount of the battery cell, based on open-circuit voltage based on the measured current value and voltage value; calculating actual discharge voltage of the battery cell, based on the calculated first voltage drop amount; calculating a second voltage drop amount of the battery cell when it is assumed that predetermined current is flowed for a predetermined time, based on the calculated actual discharge voltage; calculating virtual discharge voltage of the battery cell, based on the calculated second voltage drop amount; calculating a virtual resistance value of the battery cell, based on the calculated virtual discharge voltage; and determining allowable output power, based on the calculated virtual resistance value.

It is noted that in the description of the present invention or the like, the term "means" does not simply means a physical means, but also includes a case where a function that the means has is implemented by software. In addition, a function that one means has may be achieved by two or more physical means, and functions of two or more means may be achieved by one physical means. In addition, the term "system" refers to a logical assembly of a plurality of devices (or function modules each achieving a particular function), and it does not particularly matter whether or not the respective devices or function modules are contained in a single housing.

Advantageous Effects of Invention

According to the present invention, it is possible to appropriately predict the amount of voltage drop according to an internal state of a battery and calculate allowable output power with high precision, based on the predicted amount of voltage drop. Therefore, it is possible to suppress the battery from outputting power that exceeds the allowable output power and prevent deterioration of the battery.

Other technical features, objects, actions and effects, and advantages of the present invention will become apparent from the following embodiments described with reference to the attached drawings. Advantageous effects described herein are merely illustrative and not restrictive, and may have another advantageous effect.

Brief Description of Drawings

FIG. 1 is a block diagram illustrative of an example of a schematic configuration of a battery control system according to one embodiment of the present invention.

FIG. 2 is a block diagram illustrative of an example of a functional configuration of a control device according to the one embodiment of the present invention.

FIG. 3 is a diagram for a description of calculation of an internal resistance value of a battery performed by the control device according to the one embodiment of the present invention.

FIG. 4 is a diagram for a description of a calculation method of the amount of voltage drop of the battery performed by the control device according to the one embodiment of the present invention.

FIG. 5 is a flowchart descriptive of an example of processing to determine allowable output power performed by the control device according to the one embodiment of the present invention.

Description of Embodiments

An embodiment of the present invention will be described below with reference to the drawings. However, the embodiment to be described below is only an example, and there is no intention to exclude various modifications or application of technologies not explicitly described below. The present invention can be subjected to various modifications (such as combining embodiments) without departing from the scope of the present invention. In addition, in the following description of the drawings, the same or similar parts are designated by the same or similar reference signs. The drawings are schematic, and dimensions, ratios, or the like do not necessarily coincide with actual dimensions, ratios, or the like. There may also be portions where the dimensional relationship or the ratio differs between the drawings.

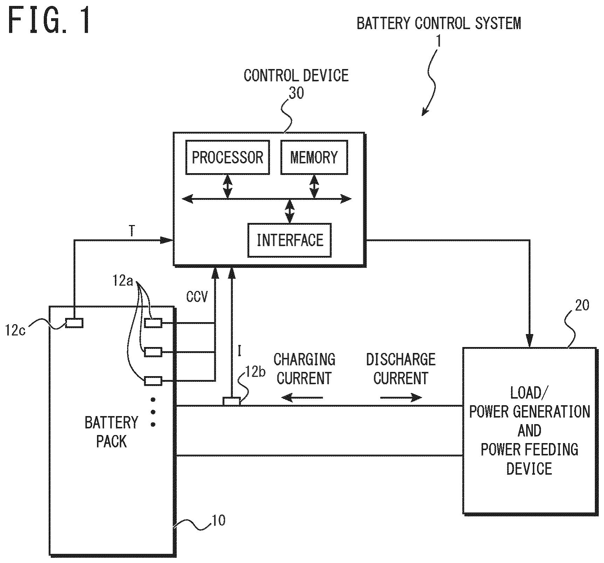

FIG. 1 is a block diagram illustrative of an example of a schematic configuration of a battery control system according to one embodiment of the present invention. As illustrated in this figure, a battery control system 1 is configured to include, for example, a battery pack 10, a load 20, and a control device 30. The battery control system 1 as described above is mounted on a vehicle.

The battery pack 10 is a battery that is formed by assembling a plurality of batteries that are referred to as unit cells and are minimum structural units. In the present disclosure, in accordance with convention, when an element is referred to as a battery, the element refers to a battery that includes the entire group of unit cells (i.e., the battery pack 10), and when an element is referred to as a battery cell, the element refers to each unit cell. The battery is typically a lithium-ion battery, but is not limited thereto.

The battery pack 10 is configured to include various types of sensors 12. The sensors 12 include, for example, voltage sensors 12a, a current sensor 12b, and a temperature sensor 12c. A voltage sensor 12a is provided for each battery cell, and measures voltage of the battery cell and outputs a measurement value of the voltage (voltage value) to the control device 30. When the vehicle and a system thereof are operating and the battery is powered on, a voltage value measured by each voltage sensor 12a is operating voltage or closed circuit voltage (CCV). As described later, to calculate the amount of voltage drop of each battery cell, open-circuit voltage (OCV) is calculated using closed circuit voltage CCV. The current sensor 12b measures a value of current output from the battery pack 10 (or current input to the battery pack 10) and outputs a measurement value of the current (current value) to the control device 30. The temperature sensor 12c measures temperature of the battery cells or some groups of battery cells and outputs a measurement value to the control device 30.

The load 20 is high-voltage equipment that consumes power supplied (output) from the battery pack 10. Typically, the load 20 is a motor to drive wheels of the vehicle. In addition, the load 20 may be configured to include a function as a power generation device or a power feeding device. Therefore, the battery pack 10 can be charged by power supplied from the load 20 serving as a power generation device or a power feeding device.

The control device 30 controls current or power of the battery pack 10 in the battery control system 1. Specifically, the control device 30 appropriately predicts an internal state of the battery cells and/or the battery, based on measurement values output from the various types of sensors 12 of the battery pack 10, determines allowable output power, based on the predicted amount of voltage drop, and controls current or power in such a way that the load 20 does not operate with power exceeding the allowable output power. The control device 30 includes a processor, a memory, an interface, and the like.

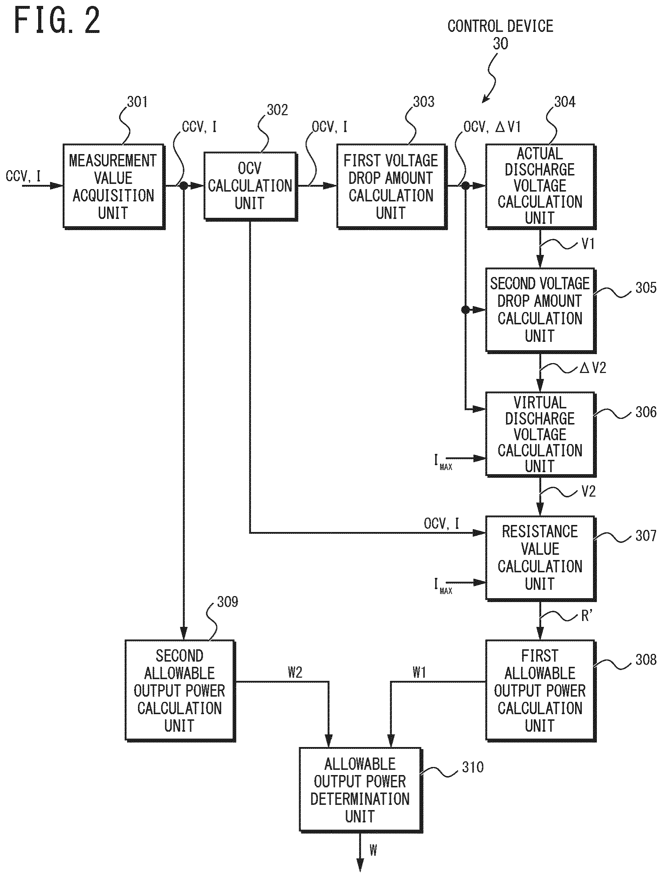

FIG. 2 is a block diagram illustrative of an example of a functional configuration of the control device according to the one embodiment of the present invention. As illustrated in the drawing, the control device 30 of the present embodiment is configured to include functional constituent elements such as a measurement value acquisition unit 301, an open-circuit voltage calculation unit (hereinafter, referred to as "OCV calculation unit") 302, a first voltage drop amount calculation unit 303, an actual discharge voltage calculation unit 304, a second voltage drop amount calculation unit 305, a virtual discharge voltage calculation unit 306, a resistance value calculation unit 307, a first allowable output power calculation unit 308, a second allowable output power calculation unit 309, and an allowable output power determination unit 310. Note that a functional constituent element may be integrally formed with another functional constituent element or may be decomposed into several functional constituent elements.

The measurement value acquisition unit 301 acquires measurement values that are measured and output by the various types of sensors 12 of the battery pack 10. Specifically, the measurement value acquisition unit 301 acquires a present voltage value (closed circuit voltage CCV) of each battery cell from one of the voltage sensors 12a and present current I from the current sensor 12b. In addition, the measurement value acquisition unit 301 acquires present temperature of the battery from the temperature sensor 12c. The measurement value acquisition unit 301 transmits the above-described acquired measurement values to the OCV calculation unit 302 and the second allowable output power calculation unit 309.

The OCV calculation unit 302 calculates present open-circuit voltage OCV of each battery cell, based on the closed circuit voltage CCV and the current I acquired via the measurement value acquisition unit 301. Specifically, the OCV calculation unit 302 calculates the open-circuit voltage OCV using the following formula:

$$OCV = CCV + I \times R$$

where R is the internal impedance of each battery cell due to the current I.

It is noted that the OCV calculation unit 302 may be configured, at the time of calculating the OCV, to correct the resistance value R, based on the temperature.

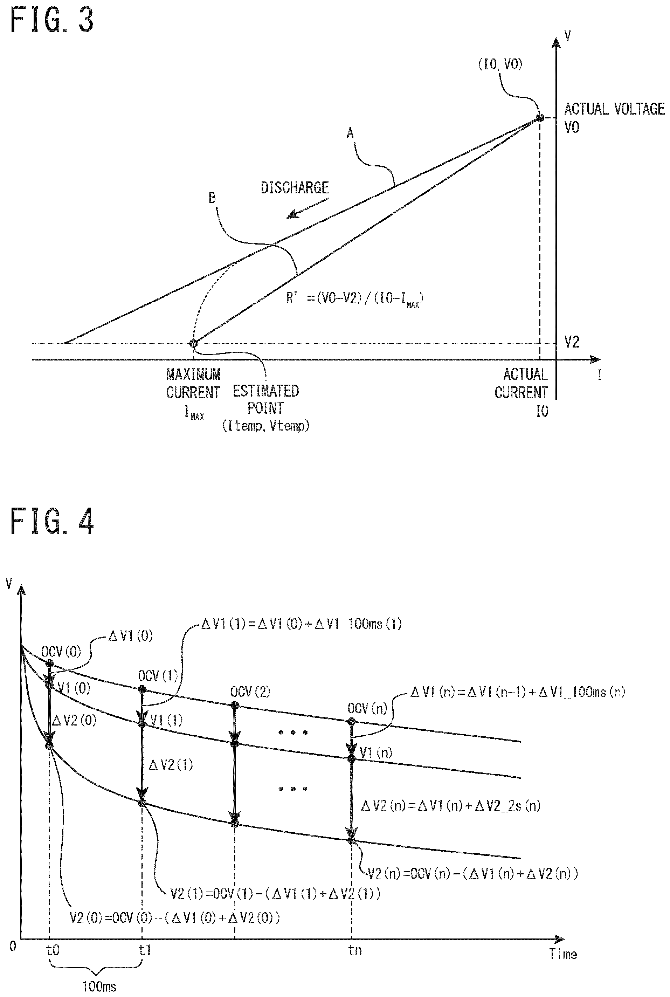

The first voltage drop amount calculation unit 303 calculates a first voltage drop amount $\Delta V1$, based on the current I and the open-circuit voltage OCV. The first voltage drop amount $\Delta V1$ indicates the amount of voltage drop after a predetermined unit time, which is calculated based on the current I. The first voltage drop amount calculation unit 303 includes a first voltage drop amount calculation model (not illustrated) for calculating the first voltage drop amount $\Delta V1$. The first voltage drop amount calculation model is formed in such a way as to calculate a voltage drop amount $\Delta V1$ for a circuit of each battery cell. Because of this configuration, it becomes possible to calculate an accurate first voltage drop amount $\Delta V1$ for each battery cell circuit. The first voltage drop amount calculation model is formed in such a manner as to use, for calculation of a present first voltage drop amount $\Delta V1$ (denoted by $\Delta V1(n)$), a past (for example, one unit time before) first voltage drop amount $\Delta V1$ (denoted by $\Delta V1(n - 1)$). The unit time is a calculation period for determination of allowable output power by the processor of the control device 30 and is, for example, 100 ms, without being limited thereto. Specifically, as illustrated in FIG. 4, the first voltage drop amount calculation unit 303 calculates, using the first voltage drop amount calculation model, the present first voltage drop amount $\Delta V1(n)$, based on the first voltage drop amount $\Delta V1(n - 1)$ calculated in the previous step (one unit time before) and a first voltage drop amount $\Delta V1\_100 ms(n)$ that is the amount of voltage drop during one unit time (e.g., 100 ms) and that is calculated based on the present current I, in accordance with the following formula.

$$\Delta V1(n) = \Delta V1(n - 1) + \Delta V1\_100 \ ms(n)$$

The first voltage drop amount calculation unit 303 transmits the calculated first voltage drop amount $\Delta V1$ to the actual discharge voltage calculation unit 304.

The actual discharge voltage calculation unit 304 calculates actual discharge voltage V1 of each battery cell, based on the calculated open-circuit voltage OCV and the present first voltage drop amount $\Delta V1$. That is, the actual discharge voltage calculation unit 304 calculates the actual discharge voltage V1 using the following formula.

$$V1 = OCV - \Delta V1$$

The actual discharge voltage calculation unit 304 transmits the calculated actual discharge voltage V1 to the second voltage drop amount calculation unit 305.

The second voltage drop amount calculation unit 305 calculates a second voltage drop amount $\Delta V2$ when it is assumed that a sufficiently large predetermined current $I_L$ flows for a predetermined time, using the calculated actual discharge voltage V1 as an initial value. In the second voltage drop amount calculation unit 305, the predetermined current $I_L$ may be, in the case of, for example, a battery mounted on a vehicle, approximately 400 A or more and may also be a maximum current allowed for the battery control system 1 by specifications. In general, the predetermined current $I_L$ has a larger value than the measured current I. The predetermined time is a time sufficiently longer than the above-described unit time and is, for example, 2 seconds, without being limited thereto. The second voltage drop amount calculation unit 305 includes a second voltage drop amount calculation model (not illustrated) for calculating the second voltage drop amount $\Delta V2$. The second voltage drop amount calculation model is configured to calculate a voltage drop amount $\Delta V2$ for a circuit of each battery cell. By this configuration, it becomes possible to calculate an accurate second voltage drop amount $\Delta V2$ for each battery cell circuit. The second voltage drop amount calculation model is formed to use, for calculation of a present second voltage drop amount $\Delta V2$ (denoted by $\Delta V2(n)$), a past (for example, one unit time before) second voltage drop amount $\Delta V2$ (denoted by $\Delta V1(n - 1)$).

Specifically, the second voltage drop amount calculation unit 305 calculates, using the second voltage drop amount calculation model, the present second voltage drop amount $\Delta V2(n)$, based on the present first voltage drop amount $\Delta V1(n)$ and a second voltage drop amount $\Delta V2\_2s(n)$ after a predetermined time (for example, 2 seconds) that is calculated based on the current I, in accordance with the following formula.

$$\Delta V2(n) = \Delta V2(n - 1) + \Delta V2\_2s(n)$$

$$= \Delta V1(n) + \Delta V2\_2s(n)$$

In other words, in the present disclosure, for calculation of the second voltage drop amount $\Delta V2$, the present first voltage drop amount $\Delta V1(n)$ is used instead of the previous second voltage drop amount $\Delta V2(n - 1)$. Because of this configuration, the amount of voltage drops when the predetermined current $I_L$ is assumed to flow for a predetermined time can be replaced by the present amount of voltage drop of the battery. The second voltage drop amount calculation unit 305 transmits the calculated second voltage drop amount $\Delta V2$ to the virtual discharge voltage calculation unit 306.

The virtual discharge voltage calculation unit 306 calculates virtual discharge voltage V2 of each battery cell, based on the calculated open-circuit voltage OCV, first voltage drop amount $\Delta V1$, and second voltage drop amount $\Delta V2$. That is, the virtual discharge voltage calculation unit 306 calculates the virtual discharge voltage V2, using the following formula.

$$V2 = OCV - (\Delta V1 + \Delta V2)$$

The virtual discharge voltage calculation unit 306 transmits the calculated virtual discharge voltage V2 to the resistance value calculation unit 307.

The resistance value calculation unit 307 calculates virtual resistance R', based on the measured and acquired voltage CCV (defined as voltage V0), the virtual discharge voltage V2, the current I, and the predetermined current $I_L$. That is, the resistance value calculation unit 307 calculates the virtual resistance R', using the following formula.

$$R' = (V0 - V2)/(I - I_L)$$

In other words, the virtual resistance R' to be calculated is internal impedance when ion diffusion in an internal state of a battery cell increases (deteriorates), and is a value estimated from a margin of the amount of voltage drop when the predetermined current $I_L$ is flowed for a predetermined time (see FIG. 3). The resistance value calculation unit 307 transmits the calculated virtual resistance R' to the first allowable output power calculation unit 308.

The first allowable output power calculation unit 308 calculates first allowable output power W1, based on the calculated virtual resistance R'. The first allowable output power calculation unit 308 includes, for example, a mapping table for calculation of the first allowable output power W1. That is, the first allowable output power calculation unit 308 accepts as input the calculated virtual resistance R' and calculates first allowable output power W1 corresponding to the virtual resistance R'. The first allowable output power calculation unit 308 may be configured to correct the resistance R, based on the measured temperature. The first allowable output power calculation unit 308 transmits the first allowable output power W1 to the allowable output power determination unit 310.

The second allowable output power calculation unit 309 calculates resistance R of each battery cell, based on the current I acquired via the measurement value acquisition unit 301 and further calculates second allowable output power W2, based on the calculated resistance R. The second allowable output power calculation unit 309 includes, for example, a mapping table for calculation of the second allowable output power W2. That is, the second allowable output power calculation unit 309 accepts as input the calculated resistance R and calculates second allowable output power W2 corresponding to the resistance R. The second allowable output power calculation unit 309 may be configured to correct the resistance R according to the measured temperature. The second allowable output power calculation unit 309 transmits the second allowable output power W2 to the allowable output power determination unit 310. It is noted that the second allowable output power calculation unit 309 is an optional constituent element.

The allowable output power determination unit 310 determines allowable output power W, based on a result of comparison between the first allowable output power W1 and the second allowable output power W2. That is, the allowable output power determination unit 310 compares the first allowable output power W1 and the second allowable output power W2 with each other and determines a value of a smaller one of the first allowable output power W1 and the second allowable output power W2 as the allowable output power W. The allowable output power determination unit 310 performs control in such a way that power supplied from the battery pack 10 does not exceed the allowable output power W. Since because of this configuration, the control device 30 prevents the amount of voltage drop from exceeding the voltage drop amount $\Delta V2$ when the predetermined current $I_L$ (for example, a maximum current $I_{MAX}$) flows through the battery control system 1, it is possible to protect the battery pack 10 and suppress acceleration of deterioration of the battery pack 10. Note that when the second allowable output power calculation unit 309 is omitted, the first allowable output power W1 calculated by the first allowable output power calculation unit 308 serves as the allowable output power W.

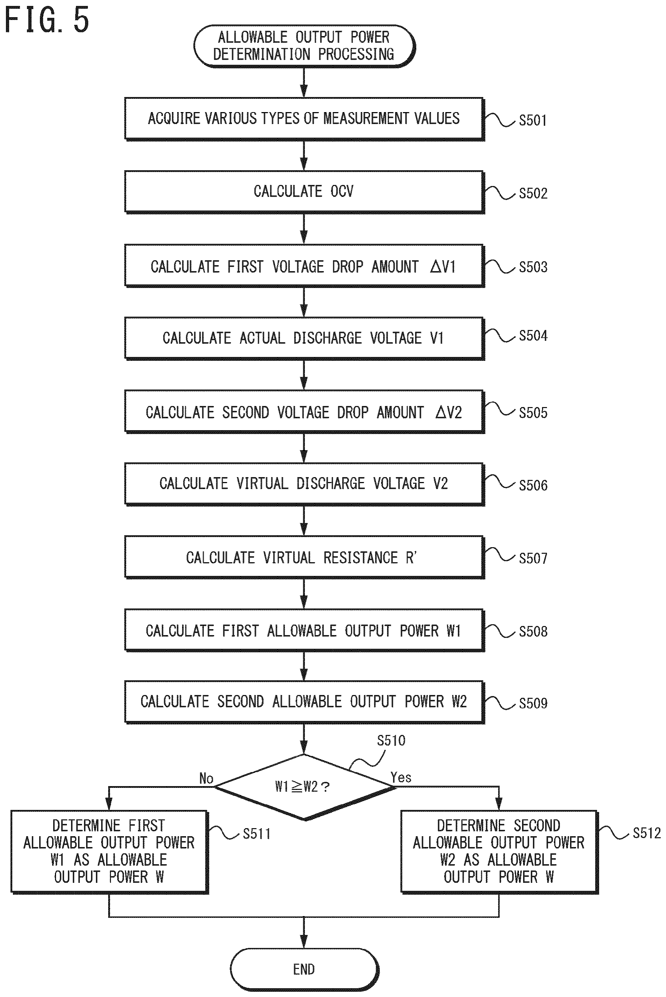

FIG. 5 is a flowchart descriptive of an example of processing to determine allowable output power performed by the control device according to the one embodiment of the present invention. Such processing is achieved by the control device 30 executing, under the control of the processor, a predetermined battery control program in collaboration with predetermined hardware resources. The control device 30 operates in such a way that the allowable output power is determined, for example, every 100 ms through such processing.

As illustrated in the drawing, the control device 30 acquires measurement values measured by the various types of sensors 12 of the battery pack 10 (S501). That is, the control device 30 acquires a present voltage value (closed circuit voltage CCV) of each battery cell from one of the voltage sensors 12a and acquires present current I from the current sensor 12b. In addition, the measurement value acquisition unit 301 can acquire present temperature T of the battery from the temperature sensor 12c.

Next, the control device 30 calculates present open-circuit voltage OCV, based on the acquired voltage CCV and current I (S502). That is, the control device 30 calculates open-circuit voltage OCV, using the internal impedance of the battery due to the current I.

Next, the control device 30 calculates a first voltage drop amount $\Delta V1$, based on the current I and the open-circuit voltage OCV, using the first voltage drop amount calculation model (S503). In this case, the control device 30 uses a first voltage drop amount $\Delta V1(n - 1)$ calculated one unit time (in the present example, 100 ms) before, to calculate a present first voltage drop amount $\Delta V1(n)$. Subsequently, the control device 30 calculates actual discharge voltage V1, based on the calculated open-circuit voltage OCV and the present first voltage drop amount $\Delta V1$ (S504).

Next, the control device 30 calculates a second voltage drop amount $\Delta V2$ when it is assumed that predetermined current $I_L$ *(e.g.,* maximum current) allowed for the battery control system 1 by specifications flows for a predetermined time, with the calculated actual discharge voltage V1 as an initial value, using the second voltage drop amount calculation model (S505). The predetermined time is, for example, 2 seconds. Subsequently, the control device 30 calculates virtual discharge voltage V2, based on the calculated open-circuit voltage OCV, first voltage drop amount $\Delta V1$, and second voltage drop amount $\Delta V2$ (S506).

Next, the control device 30 calculates virtual resistance R', based on the calculated open-circuit voltage OCV and virtual discharge voltage V2, the current I, and the predetermined current $I_L$ (S507). That is, the control device 30 estimates the virtual resistance R', based on a margin of the amount of voltage drop when the predetermined current $I_L$ is flowed for a predetermined time.

Next, the control device 30 calculates first allowable output power W1, based on the calculated virtual resistance R', using a predetermined mapping table (S508). The control device 30 may be configured to correct the resistance R according to the measured temperature.

In addition, the control device 30 calculates second allowable output power W2, based on the resistance R of the battery calculated based on the current I, using a predetermined mapping table (S509).

Next, the control device 30 determines whether or not the first allowable output power W1 calculated as described above is greater than or equal to the second allowable output power W2 (S510). When the control device 30 determines that the first allowable output power W1 is smaller than the second allowable output power W2 (No in S510), the control device 30 determines the first allowable output power W1 as the allowable output power W (S511). In other words, the allowable output power W is allowable output power based on the virtual resistance R' calculated when it is assumed that the predetermined current $I_L$ is flowed for a predetermined time. In contrast, when the control device 30 determines that the first allowable output power W1 is greater than or equal to the second allowable output power W2 (Yes in S510), the control device 30 determines the second allowable output power W2 as the allowable output power W (S512). The control device 30 performs control in such a way that power supplied from the battery pack 10 does not exceed the allowable output power W.

As described above, according to the present embodiment, since the controller 30 predicts the second voltage drop amount ΔV2 when it is assumed that a current larger than the present current I flows through the battery control system 1 for a prescribed time, the controller 30 becomes capable of determining a more accurate allowable output power W, based on the predicted second voltage drop amount ΔV2. In particular, according to the present embodiment, by predicting the second voltage drop amount ΔV2 using a sufficiently large predetermined current $I_L$ (maximum current) allowed by the specifications, it is possible to assume the worst conditions at the time of vehicle travel and determine, in any situation, the optimum allowable output power W.

In addition, according to the present embodiment, by using the actually measured and acquired current, it is possible to predict the second voltage drop amount ΔV2 when it is assumed that a large current flows from the present state of the battery. In this case, since at the time of calculating the second voltage drop amount ΔV2, the present first voltage drop amount ΔV1(n), instead of the previous second voltage drop amount ΔV2(n - 1), is used, the present state of the battery is taken into account, as a result of which it becomes possible to calculate a more accurate second voltage drop amount ΔV2.

The above-described embodiments are examples for describing the present invention and are not intended to limit the present invention only to the embodiments. The present invention can be implemented in a variety of modes without departing from the scope and spirit of the present invention.

For example, in the method disclosed herein, the steps, operations, or functions may be implemented concurrently or in different orders, as long as there is no inconsistency in the result. The described steps, operations, and functions have been provided as just examples, and in the scope without departing from the spirit of the present invention, some of the steps, operations, and functions can be omitted or can be combined with each other into one, and other steps, operations, or functions may be added.

Further, although a variety of embodiments are disclosed herein, a particular feature (technical matter) in an embodiment can be appropriately improved, and therewith, can be added to an alternative embodiment or can be replaced by the particular feature in the alternative embodiment, and such modes also fall within the spirit of the present invention.

Reference Signs List

1 Battery control system
10 Battery pack

12 Sensor

12a Voltage sensor

12b Current sensor

12c Temperature sensor

20 Load
30 Control device

301 Measurement value acquisition unit

302 Open-circuit voltage calculation unit (OCV calculation unit)
303 First voltage drop amount calculation unit
304 Actual discharge voltage calculation unit
305 Second voltage drop amount calculation unit
306 Virtual discharge voltage calculation unit
307 Resistance value calculation unit
308 First allowable output power calculation unit
309 Second allowable output power calculation unit
310 Allowable output power determination unit

**Claims**

1. A control device in a battery control system, comprising:

   a current measurement unit configured to measure a current value of current output from a battery cell constituting a battery;
   a voltage measurement unit configured to measure a voltage value of the battery cell;
   a first voltage drop amount calculation unit configured to calculate a first voltage drop amount of the battery cell, based on open-circuit voltage based on the measured current value and voltage value;
   an actual discharge voltage calculation unit configured to calculate actual discharge voltage of the battery cell, based on the calculated first voltage drop amount;
   a second voltage drop amount calculation unit configured to calculate a second voltage drop amount of the battery cell when it is assumed that predetermined current is flowed for a predetermined time, based on the calculated actual discharge voltage;
   a virtual discharge voltage calculation unit configured to calculate virtual discharge voltage of the battery cell, based on the calculated second voltage drop amount;
   a resistance value calculation unit configured to calculate a virtual resistance value of the battery cell, based on the calculated virtual discharge voltage; and
   a first allowable output power calculation unit configured to calculate first allowable output power, based on the calculated virtual resistance value.

2. The control device according to claim 1, wherein the predetermined current is a maximum current allowed by specifications in the battery control system.

3. The control device according to claim 1, wherein the first voltage drop amount calculation unit calculates the present first voltage drop amount, based on the present current value and the first voltage drop amount calculated a unit time before.

4. The control device according to claim 3, wherein the second voltage drop amount calculation unit calculates the present second voltage drop amount, based on, instead of the second voltage drop amount calculated a unit time before, the present first voltage drop amount.

5. The control device according to claim 3, wherein the predetermined time is a time longer than the unit time.

6. The control device according to claim 1, wherein the resistance value calculation unit calculates the virtual resistance value, based on the measured current value, the open-circuit voltage, the predetermined current, and the virtual discharge voltage.

7. The control device according to claim 1 further comprising:

   a second allowable output power calculation unit configured to calculate second allowable output power, based on the current and the open-circuit voltage; and
   an allowable output power determination unit configured to determine allowable output power of the battery control system, based on the calculated first allowable output power and second allowable output power.

8. The control device according to claim 7, wherein the allowable output power determination unit compares the first allowable output power and the second allowable output power with each other and determines a value of a smaller one of the first allowable output power and the second allowable output power as the allowable output power.

9. A method for determining allowable output power of a battery, the method comprising:

measuring a current value of current output from a battery cell constituting the battery and also measuring a voltage value of the battery cell;
calculating a first voltage drop amount of the battery cell, based on open-circuit voltage based on the measured current value and voltage value;
calculating actual discharge voltage of the battery cell, based on the calculated first voltage drop amount;
calculating a second voltage drop amount of the battery cell when it is assumed that predetermined current is flowed for a predetermined time, based on the calculated actual discharge voltage;
calculating virtual discharge voltage of the battery cell, based on the calculated second voltage drop amount;
calculating a virtual resistance value of the battery cell, based on the calculated virtual discharge voltage; and
determining allowable output power, based on the calculated virtual resistance value.

FIG. 1

BATTERY CONTROL SYSTEM
1

CONTROL DEVICE
30

PROCESSOR    MEMORY

INTERFACE

T

12a

CCV

12c

I

12b

CHARGING
CURRENT

DISCHARGE
CURRENT

20

BATTERY
PACK

LOAD/
POWER GENERATION
AND
POWER FEEDING
DEVICE

10

# FIG. 2

CONTROL DEVICE
30

# FIG. 3

- (I0, V0)
- ACTUAL VOLTAGE V0
- A
- DISCHARGE
- B
- $R' = (V0-V2)/(I0-I_{MAX})$
- V2
- MAXIMUM CURRENT $I_{MAX}$
- ESTIMATED POINT (Itemp, Vtemp)
- ACTUAL CURRENT I0

# FIG. 4

- $\Delta V1(1) = \Delta V1(0) + \Delta V1\_100ms(1)$
- OCV(0)
- $\Delta V1(0)$
- OCV(1)
- V1(0)
- $\Delta V2(0)$
- OCV(2)
- V1(1)
- $\Delta V1(n) = \Delta V1(n-1) + \Delta V1\_100ms(n)$
- OCV(n)
- V1(n)
- $\Delta V2(1)$
- $\Delta V2(n) = \Delta V1(n) + \Delta V2\_2s(n)$
- $V2(n) = OCV(n) - (\Delta V1(n) + \Delta V2(n))$
- $V2(1) = OCV(1) - (\Delta V1(1) + \Delta V2(1))$
- $V2(0) = OCV(0) - (\Delta V1(0) + \Delta V2(0))$
- t0, t1, tn
- 100ms

FIG. 5

```
┌─────────────────────────────┐
│    ALLOWABLE OUTPUT POWER   │
│  DETERMINATION PROCESSING   │
└─────────────────────────────┘
                │
                ▼
┌─────────────────────────────────────────┐
│ ACQUIRE VARIOUS TYPES OF MEASUREMENT VALUES │  S501
└─────────────────────────────────────────┘
                │
                ▼
┌─────────────────────────────────────────┐
│              CALCULATE OCV                │  S502
└─────────────────────────────────────────┘
                │
                ▼
┌─────────────────────────────────────────┐
│  CALCULATE FIRST VOLTAGE DROP AMOUNT △V1  │  S503
└─────────────────────────────────────────┘
                │
                ▼
┌─────────────────────────────────────────┐
│   CALCULATE ACTUAL DISCHARGE VOLTAGE V1   │  S504
└─────────────────────────────────────────┘
                │
                ▼
┌─────────────────────────────────────────┐
│  CALCULATE SECOND VOLTAGE DROP AMOUNT △V2 │  S505
└─────────────────────────────────────────┘
                │
                ▼
┌─────────────────────────────────────────┐
│  CALCULATE VIRTUAL DISCHARGE VOLTAGE V2   │  S506
└─────────────────────────────────────────┘
                │
                ▼
┌─────────────────────────────────────────┐
│      CALCULATE VIRTUAL RESISTANCE R'      │  S507
└─────────────────────────────────────────┘
                │
                ▼
┌─────────────────────────────────────────┐
│  CALCULATE FIRST ALLOWABLE OUTPUT POWER W1 │  S508
└─────────────────────────────────────────┘
                │
                ▼
┌─────────────────────────────────────────┐
│ CALCULATE SECOND ALLOWABLE OUTPUT POWER W2 │  S509
└─────────────────────────────────────────┘
                │
                ▼
          S510
        ◇ W1≧W2 ? ◇
   No ◄──        ──► Yes
```

$W1 \geqq W2$ ?

No → DETERMINE FIRST ALLOWABLE OUTPUT POWER W1 AS ALLOWABLE OUTPUT POWER W  S511

Yes → DETERMINE SECOND ALLOWABLE OUTPUT POWER W2 AS ALLOWABLE OUTPUT POWER W  S512

END

## INTERNATIONAL SEARCH REPORT

International application No.

**PCT/JP2023/011904**

**A.    CLASSIFICATION OF SUBJECT MATTER**

**H02J 7/00**(2006.01)i; **B60L 50/60**(2019.01)i; **H01M 10/44**(2006.01)i; **H01M 10/48**(2006.01)i
FI:    H02J7/00 302A; B60L50/60; H01M10/44 P; H01M10/48 P; H02J7/00 P

According to International Patent Classification (IPC) or to both national classification and IPC

**B.    FIELDS SEARCHED**

Minimum documentation searched (classification system followed by classification symbols)

H02J7/00; B60L50/60; H01M10/44; H01M10/48

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | JP 2010-220391 A (HONDA MOTOR CO., LTD.) 30 September 2010 (2010-09-30) entire text, all drawings | 1-9 |
| A | JP 2019-088069 A (KABUSHIKI KAISHA TOYOTA JIDOSHOKKI) 06 June 2019 (2019-06-06) entire text, all drawings | 1-9 |
| A | WO 2020/085097 A1 (VEHICLE ENERGY JAPAN INC.) 30 April 2020 (2020-04-30) entire text, all drawings | 1-9 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **26 May 2023** | **06 June 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2023/011904**

| Patent document cited in search report | | | Publication date (day/month/year) | Patent family member(s) | | | Publication date (day/month/year) |
|---|---|---|---|---|---|---|---|
| JP | 2010-220391 | A | 30 September 2010 | US | 2011/0221400 | A1 | |
| | | | | entire text, all drawings | | | |
| | | | | EP | 2352199 | A1 | |
| | | | | CN | 102204004 | A | |
| JP | 2019-088069 | A | 06 June 2019 | (Family: none) | | | |
| WO | 2020/085097 | A1 | 30 April 2020 | US | 2022/0003819 | A1 | |
| | | | | entire text, all drawings | | | |
| | | | | EP | 3872920 | A1 | |
| | | | | CN | 113016099 | A | |

Form PCT/ISA/210 (patent family annex) (January 2015)

**EP 4 693 798 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007141558 A